# DEMANDE DE BREVET EUROPEEN

(11) **EP 3 964 305 A1**
(43) Date de publication de la demande: **09.03.2022**
(21) Numéro de dépôt: 21193251.2
(22) Date de dépôt: 26.08.2021
(51) Int. Cl.: B22F 1/00, B22F 3/10, B22F 7/06, C22C 1/04, H01M 4/04, H01M 8/1086

(54) **PROCEDE D'INTERCONNEXION DE COMPOSANTS D'UN SYSTEME ELECTRONIQUE PAR FRITTAGE**

(30) Priorité: 03.09.2020 FR 2008955
(71) Demandeur: Commissariat à l'Energie Atomique et aux Energies Alternatives, 75015 Paris (FR); Centre National de la Recherche Scientifique, 75794 Paris Cedex 16 (FR); UNIVERSITE DE BORDEAUX, 33000 Bordeaux (FR); Institut Polytechnique de Bordeaux, 33402 Talence Cedex (FR)
(72) Inventeur: BRONCHY, Maxime, 38054 GRENOBLE Cedex 09 (FR); DUGUET, Etienne, 33130 Begles (FR); FEAUTRIER, Céline, 38054 GRENOBLE Cedex 09 (FR); TREGUER-DELAPIERRE, Mona, 33140 VILLENAVE D'ORNON (FR)
(74) Mandataire: Nony

(57) **Abrégé**

Procédé d'interconnexion de composants d'un système électronique par frittage

Procédé d'interconnexion de composants d'un système électronique, comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat ordonné dans lequel les nanoparticules métalliques sont disposées régulièrement selon trois axes, l'agent stabilisant liant entre elles et maintenant à distance les unes des autres au moins une partie des nanoparticules métalliques,
c) déliantage et frittage de la couche d'interconnexion, et
d) dépôt d'un deuxième composant au contact de la couche d'interconnexion avant ou au cours du déliantage ou du frittage.

## Description

### Domaine technique

L'invention concerne un procédé d'interconnexion de composants d'un système électronique. Elle concerne en particulier l'interconnexion d'une puce électronique, par exemple faite d'un matériau semi-conducteur avec un substrat diélectrique ou avec un autre composant électronique à haute performance.

### Technique antérieure

L'interconnexion entre les composants d'un système électronique est généralement réalisée au moyen d'une couche métallique dense pris en sandwich entre les composants et au contact de ceux-ci.

Il est connu de longue date de réaliser une telle couche d'interconnexion par brasage, c'est-à-dire par fusion d'un métal ou d'un alliage, généralement à base de plomb ou d'étain qui après refroidissement forme la couche d'interconnexion. Cependant, les alliages de brasage à base de plomb sont généralement nocifs tandis que les brasures à base d'étain sont moins performantes que les brasures à base de plomb.

Le frittage d'une pâte à fritter à base d'argent est aussi une technique connue pour interconnecter des composants électroniques. Une couche d'interconnexion frittée à base d'argent présente généralement de meilleures propriétés thermiques, et électriques qu'une brasure à l'étain. Par exemple, une couche d'interconnexion frittée en argent peut présenter une conductivité électrique supérieure à 20x10⁶ S.m⁻¹ et une conductivité thermique de l'ordre de 200 W.m⁻¹.K⁻¹ alors qu'une couche d'interconnexion brasée à base d'un alliage Sn-Ag-Cu présente une conductivité électrique de 7,5x10⁶ S.m⁻¹ et une conductivité thermique de l'ordre de 50 W.m⁻¹.K⁻¹.

Une telle pâte à fritter comporte généralement au moins 90 % en masse de particules d'argent, un solvant visqueux pour limiter l'étalement de la pâte lors de son dépôt, et non aqueux, pour limiter l'oxydation de l'argent lors du stockage de pâte. Elle peut comporter en outre des additifs pour augmenter la viscosité de la pâte, ainsi qu'un agent stabilisant pour éviter l'agglomération des particules. L'agent stabilisant peut aussi participer à améliorer la cohésion de la couche d'interconnexion.

EP 3 150 301 A1 et US 2019/0283129 A1 décrivent chacun un matériau de collage et une méthode de collage le mettant en œuvre. US 2015/0282330 A1 décrit un adhésif conducteur pour la sérigraphie. EP 3 569 329 A1 décrit une pâte de cuivre pour collage sans pression.

Cependant, le frittage nécessite la mise en œuvre d'un chauffage à une température comprise entre 200°C et 300°C, qui s'avère néfaste pour certains composants électroniques sensibles à la température. Les procédés de frittage connus actuellement ne sont notamment pas adaptés à l'interconnexion d'un composant avec un substrat polymère, d'un composant en un matériau semi-conducteur dopé, dans lequel les porteurs de charge diffusent sous l'effet de la température, ou d'un composant à forte inertie thermique, par exemple un radiateur.

Afin de diminuer la température de frittage, il est connu d'appliquer une pression sur l'assemblage de composants à fritter. Cependant, l'application d'une pression peut endommager les composants.

Un autre moyen connu pour abaisser la température de frittage est de formuler une pâte à fritter comportant des particules micrométriques et des particules nanométriques d'une taille inférieure à 100 nm. De telles particules nanométriques sont plus réactives que les microparticules. Elles frittent entre elles à des températures bien inférieures à la température de fusion de l'argent massif (961 °C). Il est en outre bien connu que la durée nécessaire au frittage diminue de manière non linéaire conjointement avec une diminution de la taille des particules, par exemple selon la loi des similitudes de Herring, comme décrit dans l'article C. Herring, Journal of Applied Physics 21, 301 (1960).

Il est encore connu, par exemple de WO 2019/065221 A1 d'adapter la forme des nanoparticules sous formes de plaquettes à base triangulaire ou hexagonale pour augmenter la surface de contact de la couche d'interconnexion avec les composants à interconnecter. Une pression peut être appliquée sur les composants pour privilégier un agencement à plat des particules et rapprocher les particules.

Par ailleurs, une couche d'interconnexion la plus dense possible est recherchée, afin d'obtenir une interconnexion mécaniquement résistante et présentant de bonnes propriétés électriques et thermiques.

La demande CN 108847395 A décrit une pâte à fritter comportant des nanoparticules d'argent ayant une forme de plaquettes, afin de privilégier un agencement à plat des plaquettes au cours du dépôt de la pâte à fritter. Cette pâte nécessite cependant l'application d'une pression au cours du frittage comprise entre 1 MPa et 5 MPa à une température supérieure à 230 °C, qui sont susceptibles d'endommager certains composants électroniques.

La demande CN 103606394 décrit une pâte de frittage à base d'argent comportant des nanoparticules sphériques ou plaquettaires revêtues d'un agent thixotrope pour améliorer les propriétés rhéologiques de la pâte de frittage et induire une organisation compacte et désordonnée des particules.

Il existe donc un besoin pour un procédé de frittage adapté à l'interconnexion de composants d'un système électronique, qui surmonte les inconvénients de l'art antérieur.

### Exposé de l'invention

L'invention concerne un procédé d'interconnexion de composants d'un système électronique, le procédé comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
   les nanoparticules métalliques comportant pour plus de 95,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat ordonné dans lequel les nanoparticules métalliques sont disposées régulièrement selon trois axes, l'agent stabilisant liant entre elles et maintenant à distance les unes des autres au moins une partie des nanoparticules métalliques,
c) déliantage et frittage de la couche d'interconnexion, et
d) dépôt d'un deuxième composant au contact de la couche d'interconnexion avant ou au cours du déliantage ou du frittage.

L'agencement ordonné des nanoparticules métalliques augmente la compacité de l'agglomérat. La densité de nanoparticules par unité de volume est augmentée, ce qui améliore la faisabilité du contact entre les nanoparticules au cours du frittage. Une couche d'interconnexion frittée particulièrement dense est ainsi obtenue.

De préférence, la couche d'interconnexion frittée présente une densité supérieure ou égale à 90 %, de préférence supérieure ou égale à 95 % de la densité dudit métal. La densité de la couche d'interconnexion est mesurée par analyse métallographique après découpe et polissage de la couche d'interconnexion frittée, par exemple par microscopie électronique.

### Solution de frittage

Les particules peuvent comporter pour plus de 99,0 %, voire pour plus de 99,9 % de leur masse un métal choisi parmi l'argent, l'or, le cuivre et leurs alliages.

De préférence, plus de 95,0 %, voire plus de 99,0 %, voire plus de 99,9 % de la masse des nanoparticules métallique est constituée par de l'argent. L'argent est préféré car il présente une conductivité électrique et une conductivité thermique supérieures à celles de l'or et du cuivre, un coût inférieur à celui de l'or et une résistance à l'oxydation supérieure à celle du cuivre.

Les nanoparticules métalliques ont une forme polyédrique. Avantageusement les nanoparticules polyédriques présentent au niveau des arêtes entre leurs faces de faibles rayons de courbure. Les arêtes et les sommets d'une nanoparticule polyédrique sont des zones particulièrement réactives qui peuvent être moins recouvertes que les faces par l'agent stabilisant. La coalescence à une température inférieure à 200 °C de nanoparticules métalliques entrant en contact les unes avec les autres est ainsi facilitée. Un tel phénomène est dénommé « *melting point depression* » en anglais.

La forme polyédrique est de préférence convexe. Elle peut être régulière. Elle peut être choisie parmi :
- un hexaèdre, de préférence un cube,
- un octaèdre, et
- un cuboctaèdre.

La forme polyédrique peut être tronquée, *i.e.* obtenue par troncature d'un polyèdre régulier. La troncature d'un polyèdre tronqué consiste en la suppression de portions pyramidales en chaque sommet du polyèdre, les portions pyramidales n'ayant au maximum qu'un sommet en commun.

De préférence, les nanoparticules métalliques sont de forme cubique, optionnellement tronquée.

Les nanoparticules métalliques forment un ensemble particulaire.

Une première fraction de l'ensemble particulaire peut être formée par des nanoparticules métalliques présentant une première forme polyédrique et une deuxième fraction de l'ensemble particulaire peut être formée par des nanoparticules métalliques présentant une deuxième forme polyédrique différente de la première forme polyédrique. La deuxième fraction peut être le complément de la première fraction dans l'ensemble particulaire.

Par ailleurs, les nanoparticules métalliques présentent un rapport d'aspect supérieur à 0,8, de préférence supérieur à 0,9, voire supérieur à 0,95, voire supérieur à 0,99, par exemple égal à 1.

Le « rapport d'aspect » d'une particule est égal au rapport du plus petit axe sur le plus grand axe du plus petit ellipsoïde circonscrit à la particule. Par exemple une particule de forme cubique qui est circonscrite à une sphère présente un rapport d'aspect égal à 1. Le «rapport d'aspect» peut être mesuré à partir d'une image acquise en microscopie électronique à balayage.

La taille de la ou des plus grandes nanoparticules de l'ensemble particulaire est de préférence inférieure à 500 nm.

La « taille » d'une particule est le rayon de la plus petite sphère circonscrite à la particule. Elle peut être mesurée à partir d'une image acquise en microscopie électronique à balayage ou par diffusion dynamique de la lumière.

Les nanoparticules métalliques présentent de préférence une taille moyenne inférieure à 100 nm, de préférence inférieure à 50 nm.

Elles peuvent présenter une taille moyenne comprise entre 1 nm et 30 nm, et notamment d'au moins 5 nm.

La taille « moyenne » d'un ensemble particulaire est la moyenne arithmétique des tailles des particules de l'ensemble particulaire.

L'ensemble particulaire peut être polydisperse ou, de préférence, monodisperse en taille. Au sens de l'invention, un ensemble particulaire monodisperse en taille est tel que l'indice de dispersion en taille, défini comme le rapport de la différence entre le quatre-vingts dixième percentile D₉₀ le dixième percentile D₁₀ des tailles de particules sur la taille médiane D₅₀ des particules, est inférieur à 0,2, de préférence inférieure à 0,1. Notamment, un ensemble particulaire monodisperse peut être tel que particules qui le composent présentent la même taille.

De préférence, les nanoparticules métalliques sont cubiques et l'ensemble granulaire qu'elle forment est monodisperse en taille. La formation d'un agglomérat dans lequel les nanoparticules cubiques sont alignées selon trois axes orthogonaux est facilitée.

L'agent stabilisant est adsorbé sur les nanoparticules métalliques. Il maintient les nanoparticules métalliques à distance et empêche leur agglomération au sein de la solution. Il favorise une dispersion homogène des nanoparticules métalliques dans le volume de la solution. En outre, il est adapté à ce qu'au cours de l'élimination du solvant, les nanoparticules s'assemblent de manière ordonnée au sein de l'agglomérat.

L'agent stabilisant peut être choisi dans le groupe formé par les tensio-actifs anioniques, les tensio-actifs amphotères, les tensio-actifs cationiques, les tensio-actifs non ioniques et leurs mélanges.

De préférence, l'agent stabilisant est choisi parmi les tensio-actifs comportant une tête hydrophile prolongée par une chaîne aliphatique hydrophobe. De tels tensio-actifs peuvent être adsorbés en surface des nanoparticules métalliques sous la forme d'un bicouche micellaire par interdigitation des chaînes aliphatiques. Le bicouche micellaire favorise l'organisation des nanoparticules au sein de l'agglomérat. Ils peuvent présenter une chaîne aliphatique comportant moins de 16 atomes de carbone.

De préférence, l'agent stabilisant est choisi parmi le chlorure de cétyltriméthylammonium, le chlorure de dodécyltriméthylammonium, le chlorure de décyltriméthylammonium, le chlorure de triméthylammonium et leurs mélanges.

De préférence, l'agent stabilisant est le chlorure de cétyltriméthylammonium, connu sous l'acronyme CTAC.

L'agent stabilisant peut être fonctionnalisé, afin d'augmenter sa réactivité avec l'agent déstabilisant et faciliter le frittage de la couche d'interconnexion, par exemple en intercalant un groupement chimique spécifique dans la chaine aliphatique, de préférence un groupement ester, éther, ou disulfure, de préférence un groupement ester afin d'introduire un fonction chimique clivable dans la chaine aliphatique.

Le solvant est de préférence polaire.

Le solvant peut être choisi parmi l'eau, l'éthanol, le 1,2-propanediol, l'éthylène glycol, le diéthylène glycol et leurs mélanges.

De préférence, le solvant est aqueux, de préférence de l'eau.

La solution de frittage peut être déposée par tout moyen connu, par exemple par sérigraphie, à la seringue, ou par impression, notamment par jet d'encre.

Le volume de solution de frittage déposé sur le premier composant peut être inférieur à 100 µl, voire inférieur à 10 µl, par exemple d'environ 1 µl.

La couche d'interconnexion déposée à l'étape a) s'étend de préférence sur une surface d'aire inférieure à 10 mm².

La solution de frittage peut comporter, en pourcentages en masse exprimés sur la base de la masse de la solution de frittage :
- entre 5,0 % et 50,0 % de nanoparticules métalliques,
- entre 0,1 % et 4,0 % de l'agent stabilisant, et
- entre 46,0 % et 94,9 % du solvant.

Les nanoparticules métalliques, l'agent stabilisant et le solvant peuvent représenter plus de 95,0 %, de préférence plus de 99,0 %, voire 100 % de la masse de la solution de frittage.

La solution de frittage peut en outre comporter un agent de texture pour augmenter la viscosité de la solution.

La solution de frittage peut comporter un autre ensemble particulaire formé de microparticules métalliques, la plus petite des microparticules présentant une taille supérieure à 1 µm. Les microparticules métalliques sont de préférence formées du même métal ou alliage que les nanoparticules métalliques.

Les microparticules métalliques peuvent présenter une forme différente des nanoparticules métalliques. En particulier, les microparticules métalliques peuvent présenter une forme plaquettaire. Par forme plaquettaire, on considère une forme polyédrique dont le rapport d'aspect est inférieur à 0,7, voire inférieur à 0,5, voire inférieure à 0,3. Les microparticules métalliques augmentent la viscosité de la solution de frittage pour faciliter son dépôt, par exemple par sérigraphie ou par seringue.

Ainsi, les microparticules, par leur taille, permettent d'augmenter le volume de la couche d'interconnexion, sans en dégrader les propriétés thermiques, mécaniques et électriques.

La solution de frittage peut comporter, en pourcentages en masse exprimés sur la base de la masse de la solution de frittage :
- entre 0,1 % et 4,0 % de l'agent stabilisant,
- entre 46,0 % et 94,9 % du solvant,
- entre 5,0 % et 50,0 % de nanoparticules métalliques et de microparticules métalliques, le rapport de la teneur en microparticules métalliques sur la somme des teneurs en nanoparticules métalliques et en microparticules métalliques étant compris entre 0,3 et 0,7.

Les nanoparticules métalliques, les microparticules métalliques, l'agent stabilisant et le solvant peuvent représenter plus de 95,0 %, de préférence plus de 99,0 %, voire 100 % de la masse de la solution de frittage.

### Elimination partielle du solvant

A l'étape b), le solvant est, au moins partiellement, éliminé de la couche d'interconnexion.

De préférence, l'élimination du solvant est opérée à une température inférieure à 200 °C.

L'élimination du solvant comporte de préférence l'évaporation, et/ou la décomposition, de préférence thermique, notamment la déshydratation, du solvant.

Le premier composant revêtu par la solution de frittage peut être disposé dans une enceinte pour mettre en œuvre l'évaporation du solvant. Par exemple, il est placé sous une cloche. La température à laquelle le solvant est chauffé pour être évaporé et/ou la pression partielle de solvant au sein de l'enceinte d'évaporation peuvent être contrôlées afin d'accélérer ou de ralentir la cinétique d'évaporation du solvant. Par exemple, la pression partielle de solvant peut être contrôlée en plaçant un récipient contenant du solvant dans l'enceinte et/ou en aspirant ou en captant le solvant évaporé.

L'évaporation du solvant peut être effectuée à une température inférieure à 50 °C, par exemple comprise entre 10 °C et 30 °C, et/ou pendant une durée comprise entre 0,5 h et 10 h, de préférence entre 2 h et 5 h.

Les résidus de solvant peuvent être décomposés thermiquement, optionnellement après évaporation. Le solvant est alors chauffé à une température supérieure ou égale à sa température de décomposition thermique. De préférence, la décomposition thermique du solvant est effectuée à une température inférieure à 200°C, et notamment d'au moins 100 °C. La décomposition thermique du solvant peut être opérée pendant une durée comprise entre 0,5 h et 10 h.

La montée en température du solvant peut être opérée en chauffant le premier composant, le flux de chaleur appliqué au premier composant étant transmis à la couche d'interconnexion. Par exemple, une face inférieure du premier composant peut être chauffée, qui est opposée à la face sur laquelle repose la couche d'interconnexion.

L'évaporation et/ou la décomposition thermique peuvent être effectuées sous une atmosphère neutre, par exemple sous argon, ou sous une atmosphère réductrice, afin d'éviter l'oxydation des nanoparticules métalliques.

Une partie ou, de préférence, tout le solvant contenu dans la couche d'interconnexion peut être éliminé.

Plus de 95 %, voire plus de 99 %, voire 100 % de la quantité du solvant contenu dans la couche d'interconnexion peut être évaporée.

Au cours de l'élimination du solvant, la concentration en nanoparticules métalliques et en agent stabilisant peut augmenter au sein de la solution de frittage. Il peut en résulter une agglomération des nanoparticules métalliques entre elles. L'agent stabilisant adsorbé sur les nanoparticules agit alors comme un liant entre les nanoparticules. En outre, il maintient les nanoparticules à distance les unes des autres au sein de l'agglomérat ainsi formé. Enfin, il favorise leur agencement de manière que l'agglomérat soit ordonné selon trois axes, de préférences orthogonaux les uns aux autres.

Les nanoparticules métalliques peuvent former un ou plusieurs agglomérats.

L'agent stabilisant peut former une couche intercalée entre les nanoparticules métalliques et au contact des nanoparticules métalliques, dont l'épaisseur est par exemple comprise entre 1 nm et 10 nm.

L'agglomérat est « ordonné », c'est-à-dire qu'il présente un agencement des nanoparticules qui est régulier, de préférence périodique, selon trois axes différents les uns des autres, et de préférence orthogonaux les uns aux autres. L'agglomérat ordonné présente de préférence un agencement cristallin selon les trois axes et est dénommé « supercristal ». De préférence, l'agglomérat est défini par répétition régulière, de préférence périodique, d'un motif élémentaire comportant des nanoparticules métalliques, selon les trois axes. En particulier, le motif élémentaire peut être répété plus de cinq fois, voire plus de dix fois, voire plus de cinquante fois selon chaque axe. Le motif élémentaire peut être cubique simple, cubique centré, cubique à faces centrées, de préférence cubique simple. Un motif élémentaire cubique simple est défini par un cube, les nanoparticules métalliques qui le composent étant disposées à équidistance les unes des autres aux sommets du cube.

Par exemple, un agglomérat ordonné est aisément différencié d'un agglomérat non ordonné par microscopie électronique à balayage.

De préférence, l'ensemble particulaire est monodisperse en taille et formé par des nanoparticules métalliques cubiques, les nanoparticules définissant une maille cubique simple, répétée périodiquement selon trois axes orthogonaux.

De préférence, un tel agglomérat est formé par un ensemble particulaire monodisperse en taille de nanoparticules d'argent d'une taille comprise entre 10 nm et 100 nm, le CTAC étant disposé entre les faces en regard des nanoparticules d'argent.

De préférence, les faces en regard des nanoparticules adjacentes sont espacées d'une distance comprise entre 1 nm et 10 nm, par exemple comprise entre 2 nm et 4 nm.

En particulier, l'agglomérat peut présenter une forme parallélépipédique, par exemple cubique, possiblement tronquée au niveau des arêtes et sommets du « supercristal ». La longueur de l'agglomérat peut être comprise entre 500 nm et 3000 nm.

### Déliantage et frittage

L'étape c) comporte le déliantage et le frittage de la couche d'interconnexion.

De préférence, le déliantage est opéré en mettant en contact l'agglomérat avec au moins un agent déstabilisant configuré pour désorber l'agent stabilisant des nanoparticules métalliques afin d'agréger et coalescer lesdites nanoparticules métalliques entre elles.

L'agent déstabilisant interagit avec l'agent stabilisant pour désorber l'agent stabilisant de la surface des nanoparticules métalliques. L'agent déstabilisant permet ainsi d'extraire ou d'éliminer, au moins en partie, l'agent stabilisant hors de l'agglomérat. L'agent stabilisant n'est alors plus intercalé entre les nanoparticules métalliques. Les nanoparticules métalliques tendent alors à entrer en contact, sous l'effet de forces attractives, et forment un agrégat. En outre, du fait de leur faible taille et de leur forme polyédrique, elles présentent une réactivité de surface élevée, notamment auprès des arêtes et sommets polyédriques, ce qui déclenche leur coalescence et le frittage de l'agrégat. La couche d'interconnexion peut ainsi être aisément frittée à une température inférieure ou égale à 200 °C, et notamment à une température supérieure ou égale à 100 °C. Elle peut en outre être frittée sans nécessiter l'application d'une pression. Des composants d'un système électronique qui sont endommagés sous l'effet d'une trop haute température ou d'une trop forte pression peuvent ainsi être aisément interconnectés en mettant en œuvre le procédé selon l'invention.

Connaissant l'agent stabilisant, l'homme du métier sait aisément choisir de manière routinière un tel agent déstabilisant.

En particulier, l'agent déstabilisant peut être choisi parmi un alcool, en particulier le méthanol, l'éthanol ou l'isopropanol le styrène sulfonate de sodium, le poly(styrène sulfonate) de sodium, l'acide trifluoroacétique et leurs mélanges.

Dans une variante de mise en œuvre où l'agent stabilisant est choisi parmi le chlorure de cétyltriméthylammonium, le chlorure de dodécyltriméthylammonium, le chlorure de décyltriméthylammonium, le chlorure de triméthylammonium et leurs mélanges, l'agent déstabilisant est de préférence choisi parmi le méthanol, l'éthanol, le styrène sulfonate de sodium, le poly(styrène sulfonate) de sodium, l'acide trifluoroacétique et leurs mélanges, de préférence le poly(styrène sulfonate) de sodium.

L'agent déstabilisant peut être déposé, par exemple sous la forme d'une goutte, sur la couche d'interconnexion.

Le déliantage peut être opéré en décomposant thermiquement l'agent stabilisant.

L'étape de déliantage et de frittage est de préférence opérée à une température inférieure à 200 °C, voire inférieure ou égale à 150 °C, et de préférence supérieure ou égale à 100 °C.

Elle peut être opérée à une température supérieure ou égale à 100 °C, par exemple à une température comprise entre 100 °C et 150 °C. Une telle étape peut ainsi être mise en œuvre lorsqu'au moins un des premier et deuxième composants est particulièrement sensible à la température. Par ailleurs, cette mise en œuvre est préférée lorsque le déliantage est effectué par mise en contact de l'agglomérat avec l'agent déstabilisant.

Selon une variante, l'étape de déliantage et de frittage peut être mise en œuvre à une température supérieure à 100°C, et par exemple comprise entre 120 °C et 190 °C, afin de densifier et de diminuer la porosité de la couche d'interconnexion, et d'augmenter la tenue mécanique de l'assemblage formé par les premier et deuxième composants et par la couche d'interconnexion. Cette mise en œuvre est préférée lorsque le déliantage est opéré par évaporation et décomposition thermique du solvant.

L'étape de déliantage et de frittage peut être conduite pendant une durée comprise entre 0,5 h et 10 h.

Par ailleurs, la température à laquelle est conduit le déliantage peut être inférieure à la température à laquelle le frittage est conduit. Le déliantage peut être conduit à des températures inférieure et supérieure respectivement à la température d'évaporation de l'agent déstabilisant. Le déliantage peut être opéré à une température inférieure à 100 °C. Ainsi, au cours du frittage, l'agent déstabilisant résiduel qui n'a pas réagi avec l'agent stabilisant peut être évaporé, de façon à réduire la présence d'éléments organique résiduel dans la couche d'interconnexion frittée.

La couche d'interconnexion peut être maintenue, et notamment chauffée, à une même température au cours de l'étape b) d'élimination du solvant et de l'étape c) de déliantage et frittage.

A l'étape c) et à l'étape d), le frittage peut être effectué sans application d'une pression, *i.e.* autre que le poids du deuxième composant. Par pression, on entend toute force, autre que le poids du premier composant ou du deuxième composant, appliquée par unité de surface sur la couche d'interconnexion.

Le frittage peut être effectué sans application d'une pression sur la couche d'interconnexion.

En variante, une pression sur la couche d'interconnexion peut être appliquée qui est de préférence inférieure à 0,1 MPa.

### Dépôt du deuxième composant

Le deuxième composant est déposé sur la couche d'interconnexion avant, au cours ou après l'étape de déliantage. Ainsi, la couche d'interconnexion adhère en fin de frittage sur le deuxième composant et connecte ainsi les premier et deuxième composants.

L'épaisseur de la couche d'interconnexion frittée peut être comprise entre 500 nm et 50 µm.

La teneur en espèces résiduelles organiques représente moins de 5 % de la masse de la couche d'interconnexion frittée.

La contrainte de cisaillement à rupture de l'assemblage formé par la couche d'interconnexion frittée et les premier et deuxième composants est de préférence supérieure à 10 MPa.

La conductivité électrique de la couche d'interconnexion frittée est de préférence supérieure à 5x10⁶ S.m⁻¹. La conductivité thermique de la couche d'interconnexion est de préférence supérieure à 30x10⁶ W.m⁻¹.K⁻¹. Le coefficient d'expansion thermique est de préférence inférieur à 30x10⁻⁶ K⁻¹.

Le premier composant et/ou le deuxième composants du système électronique peuvent être choisis parmi un support, notamment flexible et/ou pour l'impression d'un circuit imprimé, une puce en un matériau semi-conducteur, notamment retournée, une diode électroluminescente, notamment de taille inférieure à 5 mm, de préférence inférieur à 2 mm, un composant d'un système d'électronique de puissance.

Au moins l'un des premier et deuxième composants peut présenter une longueur inférieure à 1 mm et/ou une épaisseur inférieure à 500 µm. Le procédé selon l'invention, permettant un frittage à basse température est bien adapté à l'interconnexion de composants de petite taille, qui sont facilement en dommageables sous l'effet d'une température trop élevée. En particulier, l'invention est bien adaptée pour l'interconnexion à petits pas de composants.

Le support peut comporter un substrat diélectrique en un matériau polymère dont la température de fusion est inférieure à 300°C.

En particulier, selon un exemple de mise en œuvre, le premier composant est un support d'impression de circuit imprimé et le deuxième composant est un matériau semi-conducteur.

Le support d'impression de circuit imprimé peut comporter un substrat diélectrique recouvert, au moins partiellement par une couche métallique, notamment en un métal choisi parmi l'argent, l'or, le cuivre et leurs alliages, de préférence en argent ou en or. La solution de frittage peut être déposée sur la couche métallique.

La couche métallique peut être fonctionnalisée afin de réduire la mouillabilité de surface, de minimiser l'étalement de la solution de frittage sur le support, et de faciliter l'agglomération des nanoparticules au cours de l'étape b).

Elle peut être fonctionnalisée au moyen d'une substance choisie parmi un thiol aliphatique, un thiol perfluoré et leurs mélanges. De préférence, elle est fonctionnalisée au moyen d'un thiol aliphatique. Après fonctionnalisation, l'angle de mouillage de la solution de frittage sur le substrat est de préférence supérieur à 100°, de préférence supérieur à 120°.

La couche métallique peut être nettoyée, préalablement à la fonctionnalisation et au dépôt de la solution de frittage, pour supprimer les pollutions organiques naturellement présentes sur la surface de la couche d'or.

Selon un autre exemple de mise en œuvre, au moins l'un des premier et deuxième composants est un radiateur thermique d'un système d'électronique de puissance. Un tel radiateur est ainsi plus facile à interconnecter avec le procédé selon l'invention, qui peut être mis en œuvre à une température inférieure à 200 °C, qu'avec les procédés de l'art antérieur. En effet, il est difficile de chauffer le radiateur à une température supérieure à 200 °C avec les procédés de frittage connus, le temps de montée en température étant long à cause de l'inertie thermique du radiateur. Pour cette raison, avec les procédés de l'art antérieur, les radiateurs sont généralement interconnectés sur un support après l'interconnexion de puces semi-conductrices, dont les propriétés thermiques et mécaniques sont fréquemment dégradées à plus basse température que les radiateurs.

Ainsi, l'invention concerne encore l'interconnexion d'un radiateur d'un système électronique avec un premier composant du système électronique au moyen du procédé selon l'invention, suivie par l'interconnexion d'une puce électronique avec un deuxième composant du système électronique au moyen du procédé selon l'invention. Les premier et deuxième composants peuvent être identiques, par exemple un support d'impression d'un circuit imprimé.

### Autres étapes optionnelles

Le procédé peut comporter, préalablement à l'étape a), la préparation de la solution de frittage.

La préparation de la solution de frittage peut comporter la mise en solution dans le solvant d'un sel comportant le métal formant les nanoparticules métalliques et de l'agent stabilisant, suivie par la germination et la croissance des nanoparticules.

La préparation de la solution de frittage peut en outre comporter un nettoyage des nanoparticules métalliques et une dispersion des nanoparticules dans le solvant.

Par ailleurs, l'invention concerne une solution de frittage comportant un solvant, des nanoparticules métalliques dispersées dans le solvant, et un agent stabilisant adsorbé sur les nanoparticules métalliques, les nanoparticules métalliques comportant pour plus de 95,0 % de leur masse un métal choisi parmi l'argent, l'or, le cuivre et leurs alliages et présentant une forme polyédrique de rapport d'aspect supérieur à 0,8, la solution de frittage comprenant, en pourcentages en masse :
- entre 5,0 % et 50,0 % de nanoparticules métalliques,
- entre 0,1 % et 4,0 % de l'agent stabilisant, et
- entre 46,0 % et 94,9 % du solvant.

La solution de frittage peut notamment comporter une ou plusieurs des caractéristiques optionnelles décrites ci-dessus.

L'invention est illustrée au moyen des exemples qui vont suivre et du dessin qui les accompagnent dans lequel
[Fig 1] la figure 1 représente schématiquement un exemple de mode de mise en œuvre du procédé selon l'invention,
[Fig 2] la figure 2 est une photographie acquise en microscopie électronique d'un agglomérat de nanoparticules d'argent obtenu au cours d'un exemple de mise en œuvre du procédé, et
[Fig 3] la figure 3 est une photographie acquise en microscopie électronique d'un agglomérat de nanoparticules d'argent obtenu au cours d'un autre exemple de mise en œuvre du procédé.

### Exemple 1

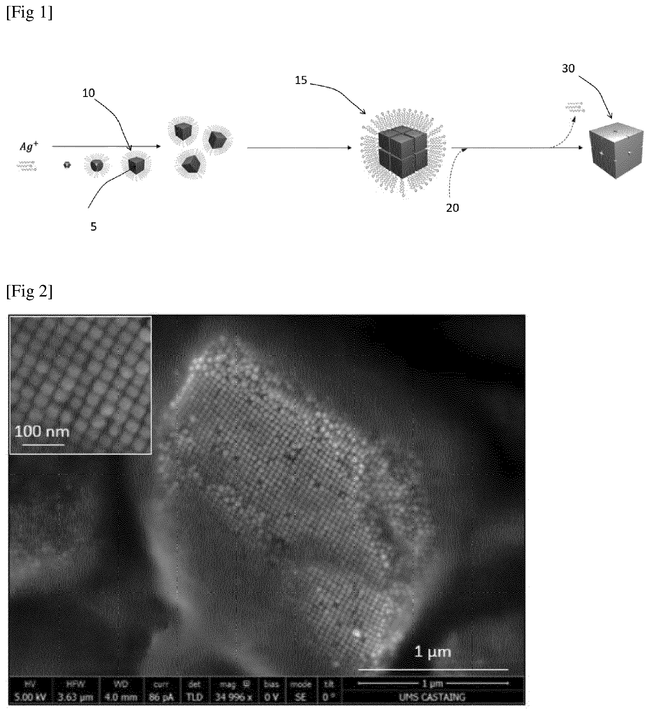

La figure 1 illustre de manière schématique un exemple de mise en œuvre du procédé selon l'invention.

Préalablement à l'étape a), une solution de base comportant des nanoparticules 5 cubiques d'argent, de taille inférieure à 30 nm, dispersées dans de l'eau déminéralisée à 18,2 MΩ et stabilisées par du CTAC 10 a été préparée au moyen de la méthode décrite dans Chem. Eur. J. 2016, 22, 2326 - 2332, doi: 10.1002/chem.201504303, qui a été modifiée comme suit. Une solution de germination contenant des germe d'argent a d'abord été préparée dans un ballon de 50 ml sous agitation. 10 ml d'une solution aqueuse de CTAC à 0,5 mM et 25 µl d'une solution aqueuse de nitrate d'argent à 0,1 M ont été introduits dans le ballon pour former un milieu réactionnel. Après 10 minutes d'homogénéisation, 0,45 ml d'une solution aqueuse de borohydrure de sodium à 0,08 M ont été ajoutés au milieu réactionnel. La solution de germination ainsi obtenue a été maintenue à 30°C sous agitation pendant 1 h. Deux volumes distincts de la solution de germination ont ensuite été utilisés pour la croissance de nanoparticules cubiques d'argent de tailles égales à 32 nm et 21 nm respectivement. Un premier volume de 43 ml et un deuxième volume de 39,5 ml respectivement d'eau déminéralisée à 18,2 MΩ ont été introduits dans deux ballons distincts de 100 ml maintenus à une température de 60°C. 200 mg de CTAC ont été introduits dans chacun des ballons. Des volumes de 1,5 ml et de 5 ml de la solution de germination ont été respectivement ajoutés dans les ballons. 500 µl d'une solution aqueuse de trifluoroacétate d'argent à 0,1 M a ensuite été ajouté dans chaque ballon. Après 20 minutes d'homogénéisation, 5 ml de solution aqueuse d'acide ascorbique à 0,1 M a été introduite ajoutés dans chaque ballon. Les solutions de croissance ainsi obtenues ont été maintenues à 60°C sous agitation pendant 1,5 h. Les nanoparticules de forme cubique ainsi synthétisées ont été lavées plusieurs fois à l'eau déminéralisé à 18,2 MΩ par centrifugation et redispersées dans un volume réduit d'eau déminéralisée à 18,2 MΩ. La solution de base a ensuite été concentrée par évaporation du solvant, par évaporation sous vide ou sous flux d'argon afin de constituer une solution de frittage comportant le pourcentage massique de solvant aqueux souhaité.

La solution de base a été lavée à l'eau déminéralisée à 18,2 MΩ par centrifugation pour éliminer l'excès de CTAC.

Les nanoparticules ont ensuite été dispersées dans un faible volume d'eau déminéralisée à 18,2 MΩ. Une solution de frittage comportant, en pourcentages en masse, 5 % de nanoparticules cubiques d'argent, 0,4 % de CTAC et 94,6 % d'eau a ainsi été obtenue, comme illustré sur la figure 1.

Une goutte d'un volume de 15 µl de solution de frittage a ensuite été déposée sur un substrat diélectrique revêtu d'une couche d'or d'une épaisseur de 30 nm. La couche d'or a été fonctionnalisée au moyen d'hexadécanethiol, qui est un thiol aliphatique, , afin de minimiser la mouillabilité du substrat et l'étalement de la solution de frittage.

Le substrat a été préalablement nettoyé au moyen d'un plasma afin d'éliminer les pollutions organiques en surface du substrat.

La solution de frittage a ensuite été évaporée sous cloche pendant 2 heures à une température de 30 °C. Un autre essai a été conduit en évaporant la solution pendant 3 heures à une température de 20 °C. La vitesse d'évaporation a été contrôle par la température régnant sous la cloche.

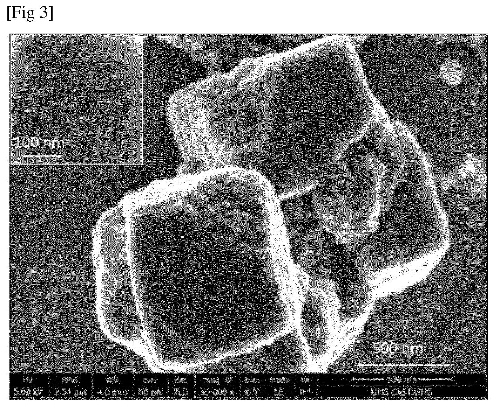

Des agglomérats 15 ordonnés ont ainsi été produits, les nanoparticules d'argent s'organisant sous la forme d'un super-cristal de structure cubique simple, comme cela peut être observé sur les figures 2 et 3. Les agglomérats se formant dans l'eau se sont ainsi déposés par sédimentation sur le substrat. Les agglomérats présentent une forme générale cubique et une taille comprise entre 500 nm et 3000 nm.

Les figures 2 et 3 sont des photographies acquises en microscopie à balayage d'agglomérats ordonnés formé à 22°C à partir de nanoparticules cubiques d'argent d'une taille égale à 31 nm et de 21 nm respectivement. Les nanoparticules adjacentes sont espacées d'environ 3 ± 1 nm.

Les agglomérats forment ainsi un film 3D qui recouvre le substrat. Ils comportent, en masse environ 8,0 % de CTAC et présentent une densité comprise entre 70 % et 80 % de la densité de l'argent. La teneur en CTAC est mesurée par analyse thermogravimétrique.

Le déliantage des agglomérats de l'exemple 1 a été effectué en déposant sur la couche d'interconnexion une goutte d'un volume de 5 µl d'éthanol à titre de déstabilisant 20 à une température de 25 °C.

Après une durée de 2 heures afin que l'éthanol désorbe suffisamment le CTAC de la surface des nanoparticules, un traitement thermique classique sous argon a été réalisé de la manière suivante : une montée en température de 45 min, un plateau de maintien en température à 185 °C pendant 2 h suivi d'un refroidissement d'une durée de 1 h, afin de fritter la couche d'interconnexion par agrégation et coalescence des nanoparticules d'argent sous la forme d'agrégats frittés 30.

Une couche d'interconnexion a ainsi été obtenue, qui présente une densité supérieure à 90 % de la densité de l'argent.

L'invention n'est bien évidemment pas limitée aux exemples de mise en œuvre du procédé présentés ci-dessus à titre illustratif.

## Revendications

1. Procédé d'interconnexion de composants d'un système électronique, le procédé comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat ordonné dans lequel les nanoparticules métalliques sont disposées régulièrement selon trois axes, l'agent stabilisant liant entre elles et maintenant à distance les unes des autres au moins une partie des nanoparticules métalliques,
c) déliantage et frittage de la couche d'interconnexion, et
d) dépôt d'un deuxième composant au contact de la couche d'interconnexion avant ou au cours du déliantage ou du frittage.

2. Procédé selon la revendication 1, la couche d'interconnexion frittée présentant une densité supérieure ou égale à 90 %, de préférence supérieure ou égale à 95 % de la densité dudit métal.

3. Procédé selon la revendication 1 ou 2, plus de 95,0 %, voire plus de 99,0 %, voire plus de 99,9 % de la masse des nanoparticules métalliques étant constituée par de l'argent.

4. Procédé selon l'une quelconque des revendications précédentes, les nanoparticules métalliques étant de forme cubique, optionnellement tronquée, et/ou l'ensemble granulaire formé par les nanoparticules métalliques étant monodisperse en taille.

5. Procédé selon l'une quelconque des revendications précédentes, la solution de frittage comportant, en pourcentages en masse exprimés sur la base de la masse de la solution de frittage :
- entre 5,0 % et 50,0 % de nanoparticules métalliques,
- entre 0,1 % et 4,0 % de l'agent stabilisant, et
- entre 46,0 % et 94,9 % du solvant.

6. Procédé selon l'une quelconque des revendications précédentes, le solvant étant choisi parmi l'eau, l'éthanol, le 1,2-propanediol, l'éthylène glycol, le diéthylène glycol et leurs mélanges, de préférence étant de l'eau.

7. Procédé selon l'une quelconque des revendications précédentes, l'agent stabilisant étant choisi parmi le chlorure de cétyltriméthylammonium, le chlorure de dodécyltriméthylammonium, le chlorure de décyltriméthylammonium, le chlorure de triméthylammonium et leurs mélanges, de préférence étant le chlorure de cétyltriméthylammonium.

8. Procédé selon l'une quelconque des revendications précédentes, l'élimination du solvant à l'étape b) comportant l'évaporation et/ou la décomposition, de préférence thermique, notamment la déshydratation, du solvant et/ou l'étape b) d'élimination du solvant étant opérée à une température inférieure à 200 °C.

9. Procédé selon l'une quelconque des revendications précédentes, le déliantage et le frittage à l'étape c) étant mis en œuvre en mettant l'agglomérat en contact avec au moins un agent déstabilisant configuré pour désorber l'agent stabilisant des nanoparticules métalliques afin d'agréger et coalescer lesdites nanoparticules métalliques entre elles, de préférence l'agent déstabilisant étant choisi parmi un alcool, en particulier le méthanol ou l'éthanol, le styrène sulfonate de sodium, le poly(styrène sulfonate) de sodium et leurs mélanges, de préférence étant le poly(styrène sulfonate) de sodium.

10. Procédé selon l'une quelconque des revendications précédentes, l'agglomérat étant défini par répétition régulière d'un motif élémentaire comportant des nanoparticules métalliques, selon les trois axes, le motif élémentaire étant cubique simple, cubique centré, ou cubique à faces centrées, de préférence cubique simple.

11. Procédé selon l'une quelconque des revendications précédentes, l'étape c) de déliantage et de frittage étant opérée à une température inférieure à 200 °C, voire inférieure ou égale à 150 °C, et de préférence supérieure ou égale à 100 °C.

12. Procédé selon l'une quelconque des revendications précédentes, selon lequel le premier composant et/ou le deuxième composants du système électronique sont choisis parmi un support, notamment flexible et/ou pour l'impression d'un circuit imprimé, une puce en un matériau semi-conducteur, notamment retournée, une diode électroluminescente, notamment de taille inférieure à 5 mm, un composant d'un système d'électronique de puissance.

13. Solution de frittage comportant un solvant, des nanoparticules métalliques dispersées dans le solvant, et un agent stabilisant adsorbé sur les nanoparticules métalliques, les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8, la solution de frittage comprenant, en pourcentages en masse :
- entre 5,0 % et 50,0 % de nanoparticules métalliques,
- entre 0,1 % et 4,0 % de l'agent stabilisant, et
- entre 46,0 % et 94,9 % du solvant.

14. Solution de frittage selon la revendication 13, dans laquelle plus de 95,0 %, voire plus de 99,0 %, voire plus de 99,9 % de la masse des nanoparticules métalliques est constituée par de l'argent.

15. Solution de frittage selon l'une des revendication 13 ou 14, dans laquelle l'agent stabilisant est choisi parmi le chlorure de cétyltriméthylammonium, le chlorure de dodécyltriméthylammonium, le chlorure de décyltriméthylammonium, le chlorure de triméthylammonium et leurs mélanges, de préférence étant le chlorure de cétyltriméthylammonium, et le solvant est choisi parmi l'eau, l'éthanol, le 1,2-propanediol, l'éthylène glycol, le diéthylène glycol et leurs mélanges.
